(19) **Europäisches Patentamt / European Patent Office / Office européen des brevets**

(11) **EP 3 767 345 A1**

(12) # EUROPEAN PATENT APPLICATION
published in accordance with Art. 153(4) EPC

(43) Date of publication:
**20.01.2021 Bulletin 2021/03**

(21) Application number: **19775870.9**

(22) Date of filing: **27.03.2019**

(51) Int Cl.:
*G02B 5/20* (2006.01)     *H01L 33/50* (2010.01)

(86) International application number:
**PCT/JP2019/013416**

(87) International publication number:
**WO 2019/189495 (03.10.2019 Gazette 2019/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.03.2018 PCT/JP2018/012584**

(71) Applicant: **Hitachi Chemical Company, Ltd.**
**Chiyoda-ku,**
**Tokyo 100-6606 (JP)**

(72) Inventors:
• **YAHATA, Tatsuya**
  **Tokyo 100-6606 (JP)**
• **KAJIMOTO, Takanori**
  **Tokyo 100-6606 (JP)**
• **KIRIGAYA, Kunihiro**
  **Tokyo 100-6606 (JP)**
• **FUKUI, Masato**
  **Tokyo 100-6606 (JP)**
• **MUKAIGAITO, Kouhei**
  **Tokyo 100-6606 (JP)**

(74) Representative: **Berggren Oy, Tampere**
**Visiokatu 1**
**33720 Tampere (FI)**

(54) **WAVELENGTH CONVERSION MEMBER, BACKLIGHT UNIT, IMAGE DISPLAY DEVICE AND CURABLE COMPOSITION**

(57)     A wavelength conversion member which contains a cured product of a curable composition that contains a quantum dot phosphor and a carboxylic acid having 1 to 17 carbon atoms.

Fig. 2

Printed by Jouve, 75001 PARIS (FR)

**Description**

Technical Field

The present invention relates to a wavelength conversion member, a backlight unit, an image display device and a curable composition.

Background Art

In recent years, in the field of image display devices such as liquid crystal display devices, improvement in color reproducibility of displays has been required. Regarding a means for improving color reproducibility, a wavelength conversion member containing a quantum dot phosphor has been focused on as described in Published Japanese Translation No. 2013-544018 of the PCT International Publication and PCT International Publication No. WO 2016/052625.

A wavelength conversion member containing a quantum dot phosphor is arranged, for example, in a backlight unit of an image display device. When a wavelength conversion member containing a quantum dot phosphor that emits red light and a quantum dot phosphor that emits green light is used, if blue light as excitation light is emitted to the wavelength conversion member, white light can be obtained from red light and green light emitted from the quantum dot phosphors and blue light that has been transmitted through the wavelength conversion member. With the development of a wavelength conversion member containing a quantum dot phosphor, the color reproducibility of a display has increased from a conventional National Television System Committee (NTSC) ratio of 72% to an NTSC ratio of 100%.

Generally, a wavelength conversion member containing a quantum dot phosphor includes a cured product obtained by curing a curable composition containing a quantum dot phosphor. The curable composition includes a thermosetting type and a photocurable type, and in consideration of productivity, a photocurable curable composition is preferably used.

Summary

Technical Problem

Incidentally, in a wavelength conversion member containing a quantum dot phosphor, in order to minimize deterioration of the quantum dot phosphor and exhibit stable performance even under an environment with light, heat, and the like, additives may be added to the curable composition used for producing the wavelength conversion member. For example, additives that are easily coordinated with the quantum dot phosphor such as oleic acid may be added to the curable composition containing a quantum dot phosphor.

However, oleic acid has a low coordination strength with respect to a quantum dot phosphor, and when energy such as heat and light is applied to a wavelength conversion member from the outside, oleic acid coordinated with the quantum dot phosphor is released, and thus the quantum dot phosphor tends to deteriorate and the emission intensity tends to decrease. Therefore, when energy such as heat and light is applied to the wavelength conversion member from the outside, it is desirable to add additives that make the quantum dot phosphor unlikely to deteriorate to the curable composition.

The present disclosure has been made in view of the above circumstances, and an objective of the present disclosure is to provide a wavelength conversion member which contains a quantum dot phosphor and has excellent moisture and heat resistance and light resistance, and a backlight unit and image display device using the same. In addition, an objective of the present disclosure is to provide a curable composition which contains a quantum dot phosphor and can form a cured product having excellent moisture and heat resistance and light resistance.

Solution to Problem

Specific solutions for achieving the above objectives are as follows.

<1> A wavelength conversion member including a cured product of a curable composition which contains a quantum dot phosphor and a carboxylic acid having 1 to 17 carbon atoms.
<2> The wavelength conversion member according to <1>,
wherein the cured product has an alicyclic structure in the skeleton of the cured product.
<3> The wavelength conversion member according to <2>,
wherein the alicyclic structure contains an isobornyl skeleton.
<4> The wavelength conversion member according to <2> or <3>,

wherein the alicyclic structure contains a tricyclodecane skeleton.

<5> The wavelength conversion member according to any one of <1> to <4>,
wherein the cured product contains a white pigment.

<6> The wavelength conversion member according to <5>,
wherein the average particle size of the white pigment is 0.1 $\mu$m to 1.0 $\mu$m.

<7> The wavelength conversion member according to any one of <1> to <6>,
wherein the quantum dot phosphor contains a compound containing at least one of Cd and In.

<8> The wavelength conversion member according to any one of <1> to <7>, further including
a covering material that covers at least a part of the cured product.

<9> The wavelength conversion member according to <8>,
wherein the covering material has a barrier property against oxygen.

<10> The wavelength conversion member according to any one of <1> to <9>,
wherein the carboxylic acid contains at least one selected from the group consisting of acetic acid, mercaptopropionic acid and methacrylic acid.

<11> The wavelength conversion member according to any one of <1> to <10>,
wherein a mass-based content ratio of the carboxylic acid to the quantum dot phosphor (carboxylic acid/quantum dot phosphor) is 0.06 to 6.5.

<12> The wavelength conversion member according to any one of <1> to <10>,
wherein the carboxylic acid is acetic acid, and a mass-based content ratio of the carboxylic acid to the quantum dot phosphor (carboxylic acid/quantum dot phosphor) is 0.5 to 6.5.

<13> The wavelength conversion member according to any one of <1> to <10>,
wherein the carboxylic acid is mercaptopropionic acid, and a mass-based content ratio of the carboxylic acid to the quantum dot phosphor (carboxylic acid/quantum dot phosphor) is 0.06 to 6.5.

<14> The wavelength conversion member according to any one of <1> to <13>,
wherein a content of the quantum dot phosphor in the curable composition with respect to a total amount of the curable composition is 0.15 mass% to 0.3 mass%.

<15> A backlight unit including the wavelength conversion member according to any one of <1> to <14>, and a light source.

<16> An image display device including the backlight unit according to <15>.

<17> A curable composition containing a quantum dot phosphor and a carboxylic acid having 1 to 17 carbon atoms.

<18> The curable composition according to <17>,
wherein a mass-based content ratio of the carboxylic acid to the quantum dot phosphor (carboxylic acid/quantum dot phosphor) is 0.06 to 6.5.

<19> The wavelength conversion member according to <17>,
wherein the carboxylic acid is acetic acid, and a mass-based content ratio of the carboxylic acid to the quantum dot phosphor (carboxylic acid/quantum dot phosphor) is 0.5 to 6.5.

<20> The wavelength conversion member according to <17>,
wherein the carboxylic acid is mercaptopropionic acid, and a mass-based content ratio of the carboxylic acid to the quantum dot phosphor (carboxylic acid/quantum dot phosphor) is 0.06 to 6.5.

<21> The wavelength conversion member according to any one of <17> to <20>,
wherein a content of the quantum dot phosphor in the curable composition with respect to a total amount of the curable composition is 0.15 mass% to 0.3 mass%.

<22> The curable composition according to any one of <17> to <21>, further including
a multifunctional (meth)acrylate compound having an alicyclic structure, a multifunctional thiol compound and a photopolymerization initiator.

<23> The curable composition according to <22>,
wherein the multifunctional (meth)acrylate compound having an alicyclic structure is a compound including a tricyclodecane skeleton.

<24> The curable composition according to any one of <17> to <21>, further including
an alkyleneoxy group-containing compound having an alkyleneoxy group and a polymerizable reactive group, a multifunctional thiol compound, and a photopolymerization initiator.

<25> The curable composition according to any one of <17> to <24>, further containing a white pigment.

<26> The curable composition according to any one of <17> to <25>, further containing an isobornyl (meth)acrylate.

Advantageous Effects of Invention

According to the present disclosure, it is possible to provide a wavelength conversion member which contains a quantum dot phosphor and has excellent moisture and heat resistance and light resistance, and a backlight unit and image display device using the same.

In addition, according to the present disclosure, it is possible to provide a curable composition which contains a quantum dot phosphor and can form a cured product having excellent moisture and heat resistance and light resistance.

Brief Description of Drawings

Fig. 1 is a schematic cross-sectional view showing an example of a schematic configuration of a wavelength conversion member.
Fig. 2 is a diagram showing an example of a schematic configuration of a backlight unit.
Fig. 3 is a diagram showing an example of a schematic configuration of a liquid crystal display device.

Description of Embodiments

Forms for implementing the present invention will be described below in detail. However, the present invention is not limited to the following embodiments. In the following embodiments, constituent elements (also including elemental steps and the like) are not essential unless otherwise specified. The same applies to numerical values and ranges thereof, and they do not limit the present invention.

In the present disclosure, when a numerical range is indicated using "to," it means that numerical values stated before and after "to" are included as a minimum value and a maximum value.

In stepwise numerical ranges described in the present disclosure, an upper limit value or a lower limit value described in one numerical range may be replaced with an upper limit value or a lower limit value of other described stepwise numerical ranges. In addition, in the numerical ranges described in the present disclosure, the upper limit value or the lower limit value of the numerical range may be replaced with values shown in examples.

In the present disclosure, each component may contain a plurality of corresponding substances. When there are a plurality of types of substances corresponding to each component in the composition, a content or a content amount of each component means a total content or content amount of the plurality of types of substances present in the composition unless otherwise noted.

In the present disclosure, a plurality of types of particles corresponding to each component may be included. When there are a plurality of types of particles corresponding to each component in the composition, the particle size of each component means a value for a mixture including the plurality of types of particles present in the composition unless otherwise noted.

In the present disclosure, the term "layer" or "film" means, when a region in which the layer or film is present is observed, not only a case in which it is formed over the entire region but also a case in which it is formed only in a part of the region.

In the present disclosure, the term "laminating" refers to laminating layers, combining two or more layers, or two or more layers that are removable.

In the present disclosure, "(meth)acryloyl" refers to at least one of acryloyl and methacryloyl, "(meth)acrylate" refers to at least one of acrylate and methacrylate, and "(meth)allyl" refers to at least one of allyl and methallyl.

In addition, in the present disclosure, a compound containing both a thiol group and an alkyleneoxy group is classified as a thiol compound.

In addition, in the present disclosure, a multifunctional (meth)acrylate compound having an alkyleneoxy group and an alicyclic structure is classified as an alkyleneoxy group-containing compound.

<Wavelength conversion member>

A wavelength conversion member of the present disclosure contains a quantum dot phosphor, and a cured product of a curable composition containing a carboxylic acid having 1 to 17 carbon atoms. The wavelength conversion member of the present disclosure may contain other constituent elements such as a covering material to be described below as necessary.

The cured product of the present disclosure may be a cured product of a curable composition of the present disclosure to be described below.

The wavelength conversion member of the present disclosure is appropriately used for image display.

The wavelength conversion member of the present disclosure contains a quantum dot phosphor, and a cured product of a curable composition containing a carboxylic acid having 1 to 17 carbon atoms (hereinafter referred to as a "specific carboxylic acid"). Therefore, when the member is left under a high temperature and high humidity environment, under a light environment, or the like, the quantum dot phosphor is unlikely to deteriorate and decrease in emission intensity is minimized, and moisture and heat resistance and light resistance are excellent. More specifically, it is considered that, since a carboxylic acid having 17 or less carbon atoms has a smaller number of carbon atoms than oleic acid, steric hindrance and the like are unlikely to occur, and a carboxy group is easily coordinated with the quantum dot phosphor. Therefore, it is speculated that, when a specific carboxylic acid is used, more ligands tend to coordinate with the quantum dot phosphor compared to when oleic acid is used, and when the member is left under a high temperature and high humidity environment, under a light environment, or the like, the quantum dot phosphor is unlikely to deteriorate.

In addition, in the wavelength conversion member of the present disclosure, since deterioration of the quantum dot phosphor is appropriately minimized, even if the content amount of the quantum dot phosphor in the cured product is smaller than that in the related art, a favorable emission intensity tends to be obtained.

In addition, the cured product may have an alicyclic structure. Here, the alicyclic structure may be derived from, for example, an alicyclic structure in a multifunctional (meth)acrylate compound having an alicyclic structure that can be contained in a curable composition to be described below.

The alicyclic structure that can be contained in the cured product is not particularly limited. Specific examples of alicyclic structures include a tricyclodecane skeleton, a cyclohexane skeleton, a 1,3-adamantane skeleton, a hydrogenated bisphenol A skeleton, a hydrogenated bisphenol F skeleton, a hydrogenated bisphenol S skeleton, and an isobornyl skeleton. Among these, a tricyclodecane skeleton or an isobornyl skeleton is preferable, and a tricyclodecane skeleton is more preferable.

The alicyclic structure contained in the cured product may be single type or at least two types.

When at least two types of alicyclic structures are contained in the cured product, examples of a combination of alicyclic structures include a combination of a tricyclodecane skeleton and an isobornyl skeleton, and a combination of a hydrogenated bisphenol A skeleton and an isobornyl skeleton. Among these, a combination of a tricyclodecane skeleton and an isobornyl skeleton is preferable.

The cured product may have an alkyleneoxy structure. When the cured product has an alkyleneoxy structure, it contributes to improving the polarity of the cured product, non-polar oxygen is unlikely to be dissolved in the components in the cured product, and oxidative deterioration of the quantum dot phosphor tends to be minimized. Here, the alkyleneoxy structure may be derived from, for example, an alkyleneoxy group in the alkyleneoxy group-containing compound that can be contained in the curable composition to be described below.

In addition, the cured product may have a sulfide structure. When the cured product has a sulfide structure, it contributes to improving the polarity of the cured product, non-polar oxygen is unlikely to be dissolved in the components in the cured product, and oxidative deterioration of the quantum dot phosphor tends to be minimized. Here, the sulfide structure may be formed by, for example, a polymerization reaction between a thiol group in the multifunctional thiol compound that can be contained in the curable composition to be described below and a polymerizable reactive group in the compound containing a polymerizable reactive group such as a carbon-carbon double bond (for example, an alkyleneoxy group-containing compound and a multifunctional (meth)acrylate compound having an alicyclic structure to be described below).

From the viewpoint of light resistance under a high temperature environment, the cured product has a sulfide structure bonded to two carbon atoms, and both carbon atoms bonded to the sulfide structure are preferably primary carbon atoms.

In addition, the cured product may have an ester structure. Here, the ester structure may be derived from, for example, an ester structure in the multifunctional (meth)acrylate compound having an alicyclic structure or the (meth)acryloyloxy group in the alkyleneoxy group-containing compound that can be contained in the curable composition to be described below.

The cured product may contain a white pigment. Details of the white pigment contained in the cured product are the same as will be described below in the section of the curable composition.

In addition, details of the specific carboxylic acid and the quantum dot phosphor in the curable composition used for producing the cured product are also the same as will be described in the section of the curable composition.

The shape of the wavelength conversion member is not particularly limited, and examples thereof include a film shape and a lens shape. When the wavelength conversion member is applied to a backlight unit to be described below, the wavelength conversion member preferably has a film shape.

When the cured product has a film shape, the average thickness of the cured product is, for example, preferably 50 μm to 200 μm, more preferably 50 μm to 150 μm, and still more preferably 80 μm to 120 μm. When the average thickness is 50 μm or more, the wavelength conversion efficiency tends to be further improved, and when the average thickness is 200 μm or less, if the product is applied to a backlight unit to be described below, the backlight unit tends to be thinner.

For example, the average thickness of the film-like cured product is obtained as an arithmetic average value of thicknesses at three arbitrary points measured using a micrometer or by observing a cross section of the cured product using a scanning electron microscope (SEM).

In addition, when the average thickness of the film-like cured product formed of a plurality of wavelength conversion members is determined, the average thickness of the wavelength conversion member and the average thickness (for example, the average thickness of the covering material) of the wavelength conversion member other than the cured product are determined using a micrometer as described above, and the average thickness of the wavelength conversion member other than the cured product may be subtracted from the average thickness of the wavelength conversion member.

In addition, when the average thickness of the film-like cured product formed of a plurality of wavelength conversion members is determined, the average thickness of the cured product is obtained as an arithmetic average value of thicknesses at three arbitrary points measured using a reflection spectroscopic film thickness meter or the like, or by observing a cross section of the cured product using a scanning electron microscope (SEM).

The wavelength conversion member may be obtained by curing one type of curable composition or curing two or more types of curable compositions. For example, when the wavelength conversion member has a film shape, the wavelength conversion member may be obtained by laminating a first cured product obtained by curing a curable composition containing a first quantum dot phosphor and a second cured product obtained by curing a curable composition containing a second quantum dot phosphor having different emission characteristics from the first quantum dot phosphor.

The wavelength conversion member can be obtained by forming a coating film of a curable composition, a molded product, or the like, performing a drying treatment as necessary, and then emitting active energy rays such as UV rays. The wavelength and emission amount of the active energy rays can be appropriately set according to the composition of the curable composition. In one embodiment, UV rays having a wavelength of 280 nm to 400 nm are emitted in an emission amount of 100 mJ/cm$^2$ to 5,000 mJ/cm$^2$. Examples of UV sources include a low pressure mercury lamp, an intermediate-pressure mercury lamp, a high pressure mercury lamp, an ultra-high pressure mercury lamp, a carbon arc lamp, a metal halide lamp, a xenon lamp, a chemical lamp, a black light lamp, and a microwave excited mercury lamp.

In order to further improve the adhesion, the cured product of the wavelength conversion member has a loss tangent (tan$\delta$) measured under conditions of a frequency of 10 Hz and a temperature of 25°C according to dynamic viscoelasticity measurement which is preferably 0.4 to 1.5, more preferably 0.4 to 1.2, and still more preferably 0.4 to 0.6. The loss tangent (tan$\delta$) of the cured product can be measured using a dynamic viscoelasticity measurement device (for example, Solid Analyzer RSA-III commercially available from Rheometric Scientific).

In addition, in order to further improve the adhesion, heat resistance, and moisture and heat resistance, the glass transition temperature (Tg) of the cured product is preferably 85°C or higher, more preferably 85°C to 160°C, and still more preferably 90°C to 120°C. The glass transition temperature (Tg) of the cured product can be measured using a dynamic viscoelasticity measurement device (for example, Solid Analyzer RSA-III commercially available from Rheometric Scientific) under a condition of a frequency of 10 Hz.

In addition, in order to further improve the adhesion and heat resistance, the cured product has a storage elastic modulus measured under conditions of a frequency of 10 Hz and a temperature of 25°C which is preferably $1\times10^7$ Pa to $1\times10^{10}$ Pa, more preferably $5\times10^7$ Pa to $1\times10^{10}$ Pa, and still more preferably $5\times10^7$ Pa to $5\times10^9$ Pa. The storage elastic modulus of the cured product can be measured using a dynamic viscoelasticity measurement device (for example, Solid Analyzer RSA-III commercially available from Rheometric Scientific).

The wavelength conversion member of the present disclosure may further contain a covering material that covers at least a part of the cured product. For example, when the cured product has a film shape, one surface or both surfaces of the film-like cured product may be covered with a film-like covering material.

In order to minimize decrease in luminous efficiency of the quantum dot phosphor, the covering material preferably has a barrier property against oxygen.

In addition, for example, when the cured product has a high polarity due to the alkyleneoxy structure or the like, since non-polar oxygen is unlikely to dissolve in components (for example, a resin component) in the cured product, the wavelength conversion member of the present disclosure may contain a covering material having a weaker barrier property against oxygen than a barrier film having the above inorganic layer.

When the wavelength conversion member contains a covering material, the material of the covering material is not particularly limited. For example, a resin may be exemplified. The type of the resin is not particularly limited, and examples thereof include polyesters such as polyethylene terephthalate (PET) and polyethylene naphthalate (PEN), polyolefins such as polyethylene (PE) and polypropylene (PP), polyamides such as nylon, and an ethylene-vinyl alcohol copolymer (EVOH). In addition, the covering material may be a material (barrier film) having a barrier layer for improving a barrier function. Regarding the barrier layer, an inorganic layer containing an inorganic substance such as alumina and silica may be exemplified.

The covering material may have a single-layer structure or a multi-layer structure. In the case of the multi-layer structure, a combination of two or more layers having different materials may be used.

When the covering material has a film shape, the average thickness of the covering material is, for example, preferably 80 $\mu$m to 150$\mu$m, more preferably 100 $\mu$m to 140 $\mu$m, and still more preferably 100 $\mu$m to 135 $\mu$m. When the average thickness is 80 $\mu$m or more, a function such as a barrier property tends to be sufficient, and when the average thickness is 150 $\mu$m or less, decrease in light transmittance tends to be minimized.

The average thickness of the film-like covering material is obtained in the same manner as in the average thickness of the film-like wavelength conversion member.

In order to maintain the reliability of the wavelength conversion member and reduce costs, the covering material preferably contains EVOH. A covering material containing EVOH tends to have a weaker water barrier property than a barrier film composed of a resin base material and an inorganic layer, but it has particularly low oxygen permeability among resins, and thus it has an oxygen barrier property sufficient for minimizing deterioration of the quantum dot phosphor.

The proportion (ethylene content) of the structural unit derived from ethylene in EVOH is not particularly limited, and can be selected in consideration of desired characteristics of the wavelength conversion member. From the viewpoint of the oxygen barrier property, a smaller ethylene content is preferable, and from the viewpoint of the strength and water resistance, a larger ethylene content is preferable. For example, the ethylene content in EVOH is preferably 20 mol% to 50 mol%, more preferably 25 mol% to 45 mol%, and still more preferably 30 mol% to 40 mol%.

The average thickness of the covering material containing EVOH is, for example, preferably 20 $\mu$m or more and more preferably 50$\mu$m or more. When the average thickness is 20 $\mu$m or more, a function such as a barrier property tends to be sufficient.

The average thickness of the covering material containing EVOH is, for example, preferably 150 $\mu$m or less, and more preferably 125$\mu$m or less. When the average thickness is 150 $\mu$m or less, decrease in light transmittance tends to be minimized.

For example, the oxygen permeability of the covering material is preferably 0.5 cm$^3$/(m$^2$·day·atm) or less, more preferably 0.3 cm$^3$/(m$^2$·day·atm) or less, and still more preferably 0.1 cm$^3$/(m$^2$·day·atm) or less.

The oxygen permeability of the covering material can be measured using an oxygen permeability measurement device (for example, OX-TRAN commercially available from MOCON) under conditions of 20°C and a relative humidity of 65%.

The upper limit value of the water vapor permeability of the covering material is not particularly limited, and may be, for example, $1\times10^{-1}$ g/(m$^2$·day) or less.

The water vapor permeability of the covering material can be measured using a water vapor permeability measurement device (for example, AQUATRAN commercially available from MOCON) under an environment of 40°C and a relative humidity of 90%.

In order to further improve light utilization efficiency, the total light transmittance of the wavelength conversion member of the present disclosure is preferably 55% or more, more preferably 60% or more, and still more preferably 65% or more. The total light transmittance of the wavelength conversion member can be measured according to a measurement method of JIS K 7136:2000.

In addition, in order to further improve light utilization efficiency, the haze of the wavelength conversion member of the present disclosure is preferably 95% or more, more preferably 97% or more, and still more preferably 99% or more. The haze of the wavelength conversion member can be measured according to the measurement method of JIS K 7136:2000.

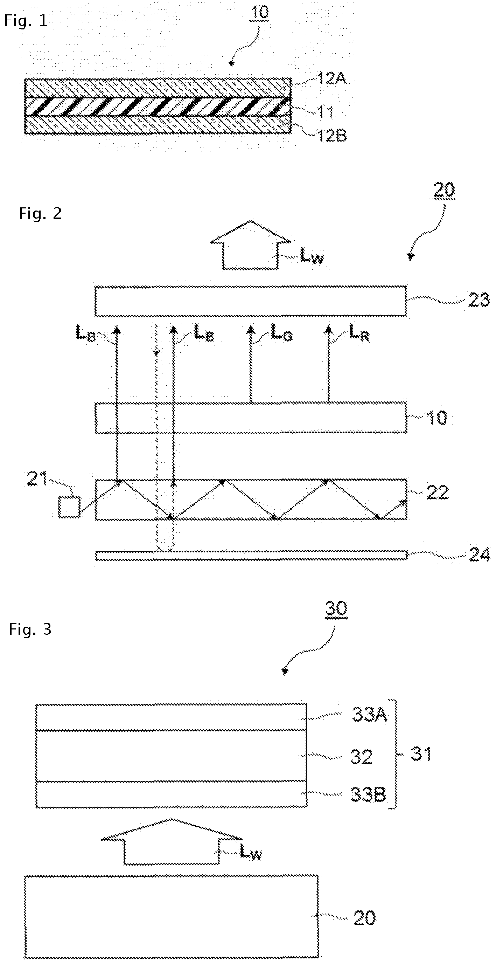

Fig. 1 shows an example of a schematic configuration of a wavelength conversion member. However, the wavelength conversion member of the present disclosure is not limited to the configuration in Fig. 1. In addition, the sizes of the cured product and the covering material in Fig. 1 are conceptual, and the relative relationship of the sizes is not limited thereto. Here, in the drawings, the same members are denoted with the same reference numerals and redundant descriptions may be omitted.

A wavelength conversion member 10 shown in Fig. 1 includes a cured product 11 as a film-like cured product and film-like covering materials 12A and 12B provided on both surfaces of the cured product 11. The types and the average thicknesses of the covering material 12A and the covering material 12B may be the same as or different from each other.

The wavelength conversion member having a configuration shown in Fig. 1 can be produced by, for example, the following known production method.

First, a curable composition to be described below is applied to a surface of a film-like covering material (hereinafter referred to as a "first covering material") that is continuously transported to form a coating film. A method of applying a curable composition is not particularly limited, and examples thereof include a die coating method, a curtain coating method, an extrusion coating method, a rod coating method, and a roll coating method.

Next, the film-like covering material (hereinafter referred to as a "second covering material") that is continuously transported is attached to the coating film of the curable composition.

Next, when active energy rays are emitted from the side of the covering material that can transmit active energy rays between the first covering material and the second covering material, a coating film is cured to form a cured product. Then, when cutting out into a specified size is performed, the wavelength conversion member having the configuration shown in Fig. 1 can be obtained.

Here, when neither the first covering material nor the second covering material can transmit active energy rays, active energy rays are emitted to the coating film before the second covering material is attached, and a cured product may be formed.

<Backlight unit>

The backlight unit of the present disclosure includes the above wavelength conversion member of the present disclosure and a light source.

In order to improve color reproducibility, the backlight unit is preferably a multi-wavelength light source. In one preferable embodiment, a backlight unit that emits blue light having an emission center wavelength in a wavelength range of 430 nm to 480 nm and an emission intensity peak having a half-value width of 100 nm or less, green light having an emission center wavelength in a wavelength range of 520 nm to 560 nm and an emission intensity peak having a half-value width of 100 nm or less, and red light having an emission center wavelength in a wavelength range of 600 nm to 680 nm and an emission intensity peak having a half-value width of 100 nm or less may be exemplified. Here, the half-value width of the emission intensity peak means a peak width in which the height is 1/2 of the height of the peak and a full width at half maximum (FWHM).

In order to further improve color reproducibility, the emission center wavelength of blue light which is emitted from the backlight unit is preferably in a range of 440 nm to 475 nm. For the same reason, the emission center wavelength of green light which is emitted from the backlight unit is preferably in a range of 520 nm to 545 nm. In addition, for the same reason, the emission center wavelength of red light which is emitted from the backlight unit is preferably in a range of 610 nm to 640 nm.

In addition, in order to further improve color reproducibility, half-value widths of emission intensity peaks of blue light, green light, and red light which are emitted from the backlight unit are all preferably 80 nm or less, more preferably 50 nm or less, still more preferably 40 nm or less, particularly preferably 30 nm or less, and most preferably 25 nm or less.

Regarding the light source of the backlight unit, for example, a light source that emits blue light having an emission center wavelength in a wavelength range of 430 nm to 480 nm can be used. Examples of light sources include a light emitting diode (LED) and a laser. When the light source that emits blue light is used, the wavelength conversion member preferably contains at least a quantum dot phosphor R that emits red light and a quantum dot phosphor G that emits green light. Therefore, white light can be obtained from red light and green light emitted from the wavelength conversion member and blue light that has been transmitted through the wavelength conversion member.

In addition, regarding the light source of the backlight unit, for example, a light source that emits ultraviolet light having an emission center wavelength in a wavelength range of 300 nm to 430 nm can be used. Examples of light sources include an LED and a laser. When the light source that emits ultraviolet light is used, the wavelength conversion member preferably contains a quantum dot phosphor R and a quantum dot phosphor G, and also a quantum dot phosphor B that emits blue light excited by excitation light. Therefore, white light can be obtained from red light, green light, and blue light emitted from the wavelength conversion member.

The backlight unit of the present disclosure may be an edge light type or a direct type.

Fig. 2 shows an example of a schematic configuration of an edge light type backlight unit. However, the backlight unit of the present disclosure is not limited to the configuration in Fig. 2. In addition, the sizes of the members in Fig. 2 are conceptual, and the relative relationship of sizes between the members is not limited thereto.

A backlight unit 20 shown in Fig. 2 includes a light source 21 that emits blue light $L_B$, a light-guiding plate 22 that guides and emits blue light $L_B$ emitted from the light source 21, the wavelength conversion member 10 that is arranged to face the light-guiding plate 22, a retroreflective member 23 that is arranged to face the light-guiding plate 22 with the wavelength conversion member 10 therebetween, and a reflective plate 24 that is arranged to face the wavelength conversion member 10 with the light-guiding plate 22 therebetween. The wavelength conversion member 10 emits red light $L_R$ and green light $L_G$ using a part of the blue light $L_B$ as excitation light, and emits the red light $L_R$ and the green light $L_G$, and blue light $L_B$ that has not become excitation light. According to the red light $L_R$, green light $L_G$, and blue light $L_B$, white light Lw is emitted from the retroreflective member 23.

<Image display device>

The image display device of the present disclosure includes the above backlight unit of the present disclosure. The image display device is not particularly limited, and examples thereof include a liquid crystal display device.

Fig. 3 shows an example of a schematic configuration of a liquid crystal display device. However, the liquid crystal display device of the present disclosure is not limited to the configuration in Fig. 3. In addition, the sizes of the members in Fig. 3 are conceptual, and the relative relationship of sizes between the members is not limited thereto.

A liquid crystal display device 30 shown in Fig. 3 includes the backlight unit 20, and a liquid crystal cell unit 31 that is arranged to face the backlight unit 20. The liquid crystal cell unit 31 has a configuration in which a liquid crystal cell 32 is arranged between a polarization plate 33A and a polarization plate 33B.

The drive method of the liquid crystal cell 32 is not particularly limited, and examples thereof include a twisted Nematic (TN) method, a super twisted nematic (STN) method, a virtical alignment (VA) method, an in-plane-switching (IPS) method, and an optically compensated birefringence (OCB) method.

<Curable composition>

The curable composition of the present disclosure contains a quantum dot phosphor, and a carboxylic acid having 1 to 17 carbon atoms. The curable composition of the present disclosure is not particularly limited to as long as it is curable with emission of active energy rays, and may further contain, for example, a multifunctional (meth)acrylate compound having an alicyclic structure or an alkyleneoxy group-containing compound, a multifunctional thiol compound and a photopolymerization initiator, and may further contain a multifunctional (meth)acrylate compound having an alicyclic structure, a multifunctional thiol compound and a photopolymerization initiator.

Hereinafter, components that can be contained in the curable composition of the present disclosure will be described in detail.

(Quantum dot phosphor)

The curable composition contains a quantum dot phosphor. The quantum dot phosphor is not particularly limited, and examples thereof include particles containing at least one selected from the group consisting of Group II-VI compounds, Group III-V compounds, Group IV-VI compounds, and Group IV compounds. From the viewpoint of luminous efficiency, the quantum dot phosphor preferably contains a compound containing at least one of Cd and In.

Specific examples of Group II-VI compounds include CdSe, CdTe, CdS, ZnS, ZnSe, ZnTe, ZnO, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, CdZnSeS, CdZnSeTe, CdZnSTe, CdHgSeS, CdHgSeTe, CdHgSTe, HgZnSeS, HgZnSeTe, and HgZnSTe.

Specific examples of Group III-V compounds include GaN, GaP, GaAs, GaSb, A1N, A1P, AlAs, AlSb, InN, InP, InAs, InSb, GaNP, GaNAs, GaNSb, GaPAs, GaPSb, AlNP, AlNAs, AlNSb, AlPAs, AlPSb, InNP, InNAs, InNSb, InPAs, InPSb, GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, and InAlPSb.

Specific examples of Group IV-VI compounds include SnS, SnSe, SnTe, PbS, PbSe, PbTe, SnSeS, SnSeTe, SnSTe, PbSeS, PbSeTe, PbSTe, SnPbS, SnPbSe, SnPbTe, SnPbSSe, SnPbSeTe, and SnPbSTe.

Specific examples of Group IV compounds include Si, Ge, SiC, and SiGe.

The quantum dot phosphor preferably has a core-shell structure. When the band gap of the compound constituting the shell is set to be wider than the band gap of the compound constituting the core, it is possible to further improve quantum efficiency of the quantum dot phosphor. Examples of combinations of a core and a shell (core/shell) include CdSe/ZnS, InP/ZnS, PbSe/PbS, CdSe/CdS, CdTe/CdS, and CdTe/ZnS.

In addition, the quantum dot phosphor may have a so-called core multi-shell structure in which the shell has a multi-layer structure. When one layer or two or more layers of a shell having a narrow band gap are laminated on a core having a wide band gap, and additionally, a shell having a wide band gap is laminated on the shell, it is possible to further improve quantum efficiency of the quantum dot phosphor.

The curable composition may contain one type of quantum dot phosphor alone or two or more types of quantum dot phosphors in combination. Examples of embodiments in which two or more types of quantum dot phosphors are combined include an embodiment in which two or more types of quantum dot phosphors having different components but having the same average particle size are combined, an embodiment in which two or more types of quantum dot phosphors having different average particle sizes but having the same components are combined, and an embodiment in which two or more types of quantum dot phosphors having different components and different average particle sizes are combined. The emission center wavelength of the quantum dot phosphor can be changed by changing at least one of the component and the average particle size of the quantum dot phosphor.

For example, the curable composition may contain a quantum dot phosphor G having an emission center wavelength in a green wavelength range of 520 nm to 560 nm and a quantum dot phosphor R having an emission center wavelength in a red wavelength range of 600 nm to 680 nm. When excitation light in a blue wavelength range of 430 nm to 480 nm is emitted to the cured product of the curable composition containing the quantum dot phosphor G and the quantum dot phosphor R, green light and red light are emitted from the quantum dot phosphor G and the quantum dot phosphor R. As a result, white light can be obtained from green light and red light emitted from the quantum dot phosphor G and the quantum dot phosphor R and blue light that has been transmitted through the cured product.

The quantum dot phosphor may be used in a quantum dot phosphor dispersion state in which it is dispersed in a dispersion medium. Examples of dispersion mediums in which the quantum dot phosphor is dispersed include water, various organic solvents and monofunctional (meth)acrylate compounds.

Examples of organic solvents that can be used as the dispersion medium include acetone, ethyl acetate, toluene, and n-hexane.

The monofunctional (meth)acrylate compound that can be used as the dispersion medium is not particularly limited as long as it is a liquid at room temperature (25°C), and examples thereof include isobornyl (meth)acrylate and dicyclopentanyl (meth)acrylate.

Among these, the dispersion medium is preferably a monofunctional (meth)acrylate compound, more preferably a monofunctional (meth)acrylate compound having an alicyclic structure, still more preferably isobornyl (meth)acrylate or dicyclopentanyl (meth)acrylate, and particularly preferably isobornyl (meth)acrylate because in this case there is no need to provide a process of volatilizing the dispersion medium when the curable composition is cured.

When a monofunctional (meth)acrylate compound is used as the dispersion medium, a mass-based content ratio of a monofunctional (meth)acrylate compound to a total amount of an alkyleneoxy group-containing compound or a multifunctional (meth)acrylate compound having an alicyclic structure (monofunctional (meth)acrylate compound/total amount of an alkyleneoxy group-containing compound or a multifunctional (meth)acrylate compound having an alicyclic structure) is preferably 0.01 to 0.30, more preferably 0.02 to 0.20, and still more preferably 0.05 to 0.20.

The mass-based proportion of the quantum dot phosphor in the quantum dot phosphor dispersion is preferably 1 mass% to 20 mass%, and more preferably 1 mass% to 10 mass%.

When the mass-based proportion of the quantum dot phosphor in the quantum dot phosphor dispersion is 1 mass% to 20 mass%, the content of the quantum dot phosphor dispersion in the curable composition with respect to a total amount of the curable composition is, for example, preferably 0.5 mass% to 10 mass%, more preferably 0.8 mass% to 7 mass%, still more preferably 1 mass% to 6 mass%, and particularly preferably 1.5 mass% to 5 mass%.

In addition, the content of the quantum dot phosphor in the curable composition with respect to a total amount of the curable composition is, for example, preferably 0.005 mass% to 1.0 mass%, more preferably 0.08 mass% to 0.7 mass%, still more preferably 0.1 mass% to 0.6 mass%, and particularly preferably 0.15 mass% to 0.5 mass%, and in order to obtain superior moisture and heat resistance and light resistance, the content is most preferably 0.15 mass% to 0.3 mass%. When the content of the quantum dot phosphor is 0.005 mass% or more, a sufficient emission intensity when excitation light is emitted to the cured product tends to be obtained, and when the content of the quantum dot phosphor is 1.0 mass% or less, aggregation of the quantum dot phosphor tends to be minimized.

(Carboxylic acid having 1 to 17 carbon atoms)

The curable composition of the present disclosure contains a carboxylic acid having 1 to 17 carbon atoms (specific carboxylic acid). In order to prevent strains on the surface of the cured product, obtain excellent reliability of the cured product, reduce steric hindrance, and easily coordinate with the quantum dot phosphor, the specific carboxylic acid is preferably a carboxylic acid having 2 to 12 carbon atoms, more preferably a carboxylic acid having 2 to 10 carbon atoms, still more preferably a carboxylic acid having 3 to 8 carbon atoms, particularly preferably a carboxylic acid having 3 to 6 carbon atoms, and most preferably a carboxylic acid having 3 to 5 carbon atoms.

Here, carbon atoms of the carboxy group are included in the number of carbon atoms in the specific carboxylic acid.

The specific carboxylic acid may be an unsaturated carboxylic acid or a saturated carboxylic acid. For example, by reacting a carbon-carbon double bond in the unsaturated carboxylic acid with a thiol group in the multifunctional thiol compound, the specific carboxylic acid is unlikely to be strained on the surface of the cured product and from the viewpoint of excellent reliability of the cured product, an unsaturated carboxylic acid is preferable, and methacrylic acid, acrylic acid, or the like is more preferable.

The specific carboxylic acid may be a carboxylic acid having one or more carboxy groups or a carboxylic acid having two or more carboxy groups.

The specific carboxylic acid may have a substituent. Specific examples of substituents include a thiol group, an amino group, a hydroxy group, an alkoxy group, an acyl group, a sulfonic acid group, an aryl group, a halogen atom, a methacrylic group, and an acrylic group. The number of carbon atoms in the specific carboxylic acid does not include carbon atoms in the substituent.

Specific examples of specific carboxylic acids include formic acid, acetic acid, propionic acid, butyric acid, isobutyric acid, valeric acid, isovaleric acid, caproic acid, 2-ethylbutyric acid, enanthic acid, caprylic acid, pelargonic acid, capric acid, lauric acid, myristic acid, palmitic acid, margaric acid, methacrylic acid, acrylic acid, fumaric acid, maleic acid, mercaptoacetic acid, mercaptopropionic acid, mercaptobutyric acid, mercaptovaleric acid, lactic acid, malic acid, citric acid, benzoic acid, phenylacetic acid, phenylpropionic acid, phthalic acid, isophthalic acid, terephthalic acid, salicylic acid, and ε-aminocaproic acid. Among these, the specific carboxylic acid preferably includes at least one selected from the group consisting of acetic acid, mercaptopropionic acid and methacrylic acid.

Specific carboxylic acids may be used alone or two or more thereof may be used in combination.

In addition, from the viewpoint of the reliability of the cured product and coordination with the quantum dot phosphor, a mass-based content ratio of the specific carboxylic acid to the quantum dot phosphor (specific carboxylic acid/quantum dot phosphor) is preferably 0.06 to 6.5, more preferably 0.06 to 6.2, still more preferably 0.08 to 5.5, and particularly preferably 0.09 to 5.3.

When the specific carboxylic acid is acetic acid, in order to obtain superior moisture and heat resistance and light resistance, specific carboxylic acid/quantum dot phosphor is preferably 0.5 to 6.5, more preferably 4.0 to 6.5, still more preferably 4.5 to 6.5, and particularly preferably 4.7 to 6.3.

When the specific carboxylic acid is mercaptopropionic acid, in order to obtain superior moisture and heat resistance and light resistance, specific carboxylic acid/quantum dot phosphor is preferably 0.06 to 6.5, more preferably 0.06 to 1.2, still more preferably 0.1 to 1.0, and particularly preferably 0.3 to 0.8.

In addition, the curable composition of the present disclosure may or may not contain a carboxylic acid having 18 or more carbon atoms such as oleic acid.

(Multifunctional (meth)acrylate compound having an alicyclic structure)

The curable composition of the present disclosure may contain a multifunctional (meth)acrylate compound having an alicyclic structure. The multifunctional (meth)acrylate compound having an alicyclic structure is a multifunctional (meth)acrylate compound having an alicyclic structure in its skeleton and having two or more (meth)acryloyl groups in one molecule. Specific examples thereof include alicyclic (meth)acrylates such as tricyclodecane dimethanol di(meth)acrylate, cyclohexanedimethanol di(meth)acrylate, 1,3-adamantane dimethanol di(meth)acrylate, hydrogenated bisphenol A (poly)ethoxydi(meth)acrylate, hydrogenated bisphenol A (poly)propoxydi(meth)acrylate, hydrogenated bisphenol F (poly)ethoxydi(meth)acrylate, hydrogenated bisphenol F (poly)propoxydi(meth)acrylate, hydrogenated bisphenol S (poly)ethoxydi(meth)acrylate, and hydrogenated bisphenol S (poly)propoxydi(meth)acrylate.

From the viewpoint of the heat resistance of the curable composition, the alicyclic structure contained in the multifunctional (meth)acrylate compound having an alicyclic structure preferably includes a tricyclodecane skeleton. Regarding the multifunctional (meth)acrylate compound in which the alicyclic structure includes a tricyclodecane skeleton, tricyclodecane dimethanol di(meth)acrylate is preferable.

When the curable composition contains a multifunctional (meth)acrylate compound having an alicyclic structure, the content of the multifunctional (meth)acrylate compound having an alicyclic structure in the curable composition with respect to a total amount of the curable composition is, for example, is preferably 40 mass% to 85 mass%, more preferably 60 mass% to 80 mass%, and still more preferably 70 mass% to 80 mass%. When the content of the multifunctional (meth)acrylate compound having an alicyclic structure is within the above range, the heat resistance of the cured product tends to be further improved.

The curable composition may contain single type of a multifunctional (meth)acrylate compound having an alicyclic structure or contain two or more types of multifunctional (meth)acrylate compounds having an alicyclic structure in combination.

(Multifunctional thiol compound)

The curable composition of the present disclosure may contain a multifunctional thiol compound. When the curable composition contains a multifunctional thiol compound, an ene-thiol reaction occurs between the multifunctional (meth)acrylate compound having an alicyclic structure or the like and the multifunctional thiol compound when the curable composition is cured, and the heat resistance of the cured product tends to be further improved. In addition, when the curable composition contains a multifunctional thiol compound, optical properties of the cured product tends to be further improved. The multifunctional thiol compound may be a compound having two or more thiol groups in one molecule and is preferably a compound having three or four thiol groups in one molecule.

From the viewpoint of light resistance under a high temperature environment, the multifunctional thiol compound preferably has at least one thiol group to which a primary carbon atom is bonded.

The curable composition may contain both a thiol compound having at least one thiol group to which a primary carbon atom is bonded and a thiol compound having at least one thiol group to which a secondary carbon atom or a tertiary carbon atom is bonded.

Specific examples of multifunctional thiol compounds include ethylene glycol bis(3-mercaptopropionate), diethylene glycol bis(3-mercaptopropionate), tetraethylene glycol bis(3-mercaptopropionate), 1,2-propylene glycol bis(3-mercaptopropionate), diethylene glycol bis(3-mercaptobutyrate), 1,4-butanediol bis(3-mercaptopropionate), 1,4-butanediol bis(3-mercaptobutyrate), 1,8-octanediol bis(3-mercaptopropionate), 1,8-octanediol bis(3-mercaptobutyrate), hexanediol bisthioglycolate, trimethylolpropane tris(3-mercaptopropionate), trimethylolpropane tris(3-mercaptobutyrate), trimethylolpropane tris(3-mercaptoisobutyrate), trimethylolpropane tris(2-mercaptoisobutyrate), trimethylolpropane tristhioglycolate, tris-[(3-mercaptopropionyloxy)-ethyl]-isocyanurate, trimethylolethane tris(3-mercaptobutyrate), pentaerythritol tetrakis(3-mercaptopropionate), pentaerythritol tetrakis(3-mercaptobutyrate), pentaerythritol tetrakis(3-mercaptoisobutyrate), pentaerythritol tetrakis(2-mercaptoisobutyrate), dipentaerythritol hexakis(3-mercaptopropionate), dipentaerythritol hexakis(2-mercaptopropionate), dipentaerythritol hexakis(3-mercaptobutyrate), dipentaerythritol hexakis(3-mercaptoisobutyrate), dipentaerythritol hexakis(2-mercaptoisobutyrate), pentaerythritol tetrakis thioglycolate, dipentaerythritol hexakis thioglycolate, and 1,4-bis(3-mercaptobutyryloxy)butane.

The curable composition of the present disclosure may contain a monofunctional thiol compound having one thiol group in one molecule.

Specific examples of monofunctional thiol compounds include hexanethiol, 1-heptanethiol, 1-octanethiol, 1-nonanethiol, 1-decanethiol, 3-mercaptopropionic acid, methyl mercaptopropionate, methoxybutyl mercaptopropionate, octyl mercaptopropionate, tridecyl mercaptopropionate, 2-ethylhexyl-3-mercaptopropionate, and n-octyl-3 -mercaptopropionate.

When the curable composition contains the above multifunctional (meth)acrylate compound having an alicyclic structure, the content of the thiol compound in the curable composition (a total amount of the multifunctional thiol compound and monofunctional thiol compounds used as necessary, preferably the multifunctional thiol compound) with respect to a total amount of the curable composition is, for example, preferably 5 mass% to 50 mass%, more preferably 5 mass% to 40 mass%, still more preferably 10 mass% to 30 mass%, and particularly preferably 15 mass% to 25 mass%. In this case, the cured product forms a denser crosslinked structure due to the ene-thiol reaction with the multifunctional (meth)acrylate compound having an alicyclic structure, and the moisture and heat resistance tends to be further improved.

When the curable composition contains an alkyleneoxy group-containing compound to be described below, the content of the thiol compound in the curable composition (a total amount of the multifunctional thiol compound and monofunctional thiol compounds used as necessary, preferably the multifunctional thiol compound) with respect to a total amount of the curable composition is, for example, preferably 15 mass% to 70 mass%, more preferably 20 mass% to 65 mass%, still more preferably 25 mass% to 60 mass%, and particularly preferably 30 mass% to 50 mass%. In this case, oxidative deterioration of the quantum dot phosphor tends to be minimized, the shape of the cured product is appropriately maintained, and the strength of the cured product tends to be excellent.

The mass-based proportion of the multifunctional thiol compound to the total amount of the multifunctional thiol compound and monofunctional thiol compounds used as necessary is preferably 60 mass% to 100 mass%, more preferably 70 mass% to 100 mass%, and still more preferably 80 mass% to 100 mass%.

A ratio of the total number of thiol groups in the thiol compound (a total amount of the multifunctional thiol compound and monofunctional thiol compounds used as necessary, preferably the multifunctional thiol compound) to the total number of polymerizable reactive groups in the multifunctional (meth)acrylate compound having an alicyclic structure (total number of thiol groups/total number of polymerizable reactive groups) is preferably 0.5 to 4.0, more preferably 0.6 to 3.0, still more preferably 0.6 to 2.0, and particularly preferably 0.7 to 1.5.

A ratio of the total number of thiol groups in the thiol compound (a total amount of the multifunctional thiol compound and monofunctional thiol compounds used as necessary, preferably the multifunctional thiol compound) to the total number of polymerizable reactive groups in the alkyleneoxy group-containing compound (total number of thiol groups/total number of polymerizable reactive groups) is preferably 0.5 to 5.0, more preferably 0.8 to 4.0, still more preferably 1.0 to 3.5, and particularly preferably 1.2 to 3.0.

(Photopolymerization initiator)

The curable composition of the present disclosure contains a photopolymerization initiator. The photopolymerization initiator is not particularly limited, and specific examples thereof include a compound that generates radicals according to emission of active energy rays such as UV rays.

Specific examples of photopolymerization initiators include aromatic ketone compounds such as benzophenone, N,N'-tetraalkyl-4,4'-diaminobenzophenone, 2-benzyl-2-dimethylamino-1-(4-morpholinophenyl)-butanone-1,2-methyl-1-[4-(methylth io)phenyl]-2-morpholino-propanone-1,4,4'-bis(dimethylamino)benzophenone (also referred to as "Michler's ketone"), 4,4'-bis(diethylamino)benzophenone, 4-methoxy-4'-dimethylaminobenzophenone, 1-hydroxycyclohexyl phenyl ketone, 1-(4-isopropylphenyl)-2-hydroxy-2-methylpropan-1-one, 1-(4-(2-hydroxyethoxy)-phenyl)-2-hydroxy-2-methyl-1-propan-1-one, and 2-hydroxy-2-methyl-1-phenylpropan-1-one; quinone compounds such as alkylanthraquinone and phenanthrenequinone; benzoin compounds such as benzoin and alkylbenzoin; benzoin ether compounds such as benzoin alkyl ether and benzoin phenyl ether; benzyl derivatives such as benzyl dimethyl ketal; 2,4,5-triarylimidazole dimers such as 2-(o-chlorophenyl)-4,5-diphenylimidazole dimer, 2-(o-chlorophenyl)-4,5-di(m-methoxyphenyl)imidazole dimer, 2-(o-fluorophenyl)-4,5-diphenylimidazole dimer, 2-(o-methoxyphenyl)-4,5-diphenylimidazole dimer, 2,4-di(p-methoxyphenyl)-5-phenylimidazole dimer, and 2-(2,4-dimethoxyphenyl)-4,5-diphenylimidazole dimer; acridine derivatives such as 9-phenylacridine and 1,7-(9,9'-acridinyl)heptane; oxime ester compounds such as 1,2-octanedione 1-[4-(phenylthio)-2-(O-benzoyloxime)], and ethanone 1-[9-ethyl-6-(2-methylbenzoyl)-9H-carbazol-3-yl]-1-(O-acetyloxime); coumarin compounds such as 7-diethylamino-4-methylcoumarin; thioxanthone compounds such as 2,4-diethylthioxanthone; and acylphosphine oxide compounds such as 2,4,6-trimethylbenzoyl-diphenyl-phosphine oxide, and 2,4,6-trimethylbenzoyl-phenyl-ethoxy-phosphine oxide. The curable composition may contain single type of photopolymerization initiator or may contain two or more types of photopolymerization initiators in combination.

From the viewpoint of curability, the photopolymerization initiator is preferably at least one selected from the group consisting of acylphosphine oxide compounds, aromatic ketone compounds, and oxime ester compounds, more preferably at least one selected from the group consisting of acylphosphine oxide compounds and aromatic ketone compounds, and still more preferably an acylphosphine oxide compound.

The content of the photopolymerization initiator in the curable composition with respect to a total amount of the curable composition is, for example, preferably 0.1 mass% to 5 mass%, more preferably 0.1 mass% to 3 mass%, and still more preferably 0.3 mass% to 1.5 mass%. When the content of the photopolymerization initiator is 0.1 mass% or more, the sensitivity of the curable composition tends to be sufficient, and when the content of the photopolymerization initiator is 5 mass% or less, the influence of the curable composition on the hue and decrease in the storage stability tend to be minimized.

(Alkyleneoxy group-containing compound)

The curable composition of the present disclosure may contain an alkyleneoxy group-containing compound having an alkyleneoxy group and a polymerizable reactive group (in the present disclosure, simply referred to as an "alkyleneoxy group-containing compound"). Here, the curable composition of the present disclosure preferably contains a multifunctional (meth)acrylate compound having an alicyclic structure or an alkyleneoxy group-containing compound.

The alkyleneoxy group-containing compound preferably has two or more polymerizable reactive groups, and from the viewpoint of the moisture and heat resistance under a high temperature environment, it has preferably 2 to 5 polymerizable reactive groups, more preferably 2 to 4 polymerizable reactive groups, particularly preferably 2 or 3 polymerizable reactive groups, and most preferably 2 polymerizable reactive groups. When two or more polymerizable reactive groups are included, the adhesion and light resistance of the cured product with respect to the covering material can be further improved.

Examples of polymerizable reactive groups include a functional group having an ethylenic double bond, and more specific examples thereof include a (meth)acryloyl group.

Regarding the alkyleneoxy group, for example, an alkyleneoxy group having 2 to 4 carbon atoms is preferable, an alkyleneoxy group having 2 or 3 carbon atoms is more preferable, and an alkyleneoxy group having 2 carbon atoms is still more preferable.

The alkyleneoxy group-containing compound may have one alkyleneoxy group or two or more alkyleneoxy groups.

The alkyleneoxy group-containing compound may be a polyalkyleneoxy group-containing compound having a polyalkyleneoxy group containing a plurality of alkyleneoxy groups.

Regarding the alkyleneoxy group-containing compound, a compound having 2 to 30 alkyleneoxy groups is preferable, a compound having 2 to 20 alkyleneoxy groups is more preferable, a compound having 3 to 10 alkyleneoxy groups is still more preferable, and a compound having 3 to 5 alkyleneoxy groups is particularly preferable.

The alkyleneoxy group-containing compound preferably has a bisphenol structure. Therefore, the light resistance tends to be better. Examples of bisphenol structures include a bisphenol A structure and a bisphenol F structure, among these, a bisphenol A structure is preferable.

Specific examples of alkyleneoxy group-containing compounds include alkoxyalkyl (meth)acrylates such as dipentaerythritol hexa(meth)acrylate and butoxyethyl (meth)acrylate; polyalkylene glycol monoalkyl ether (meth)acrylates such as diethylene glycol monoethyl ether (meth)acrylate, triethylene glycol monobutyl ether (meth)acrylate, tetraethylene glycol monomethyl ether (meth)acrylate, hexaethylene glycol monomethyl ether (meth)acrylate, octaethylene glycol monomethyl ether (meth)acrylate, nonaethylene glycol monomethyl ether (meth)acrylate, dipropylene glycol monomethyl ether (meth)acrylate, heptapropylene glycol monomethyl ether (meth)acrylate, and tetraethylene glycol monoethyl ether (meth)acrylate; polyalkylene glycol monoaryl ether (meth)acrylates such as hexaethylene glycol monophenyl ether (meth)acrylate; (meth)acrylate compounds having a heterocycle such as tetrahydrofurfuryl (meth)acrylate; (meth)acrylate compounds having a hydroxyl group such as triethylene glycol mono(meth)acrylate, tetraethylene glycol mono(meth)acrylate, hexaethylene glycol mono(meth)acrylate, and octapropylene glycol mono(meth)acrylate; (meth)acrylate compounds having a glycidyl group such as glycidyl (meth)acrylate; polyalkylene glycol di(meth)acrylates such as polyethylene glycol di(meth)acrylate, and polypropylene glycol di(meth)acrylate; tri(meth)acrylate compounds such as ethylene oxide-added trimethylolpropane tri(meth)acrylate; tetra(meth)acrylate compounds such as ethylene oxide-added pentaerythritol tetra(meth)acrylate; and bisphenol type di(meth)acrylate compounds such as ethoxylated bisphenol A type di(meth)acrylate, propoxylated bisphenol A type di(meth)acrylate, and propoxylated ethoxylated bisphenol A type di(meth)acrylate.

Regarding the alkyleneoxy group-containing compound, among these, ethoxylated bisphenol A type di(meth)acrylate, propoxylated bisphenol A type di(meth)acrylate and ethoxylated bisphenol A type di(meth)acrylate are preferable, and ethoxylated bisphenol A type di(meth)acrylate is more preferable.

The alkyleneoxy group-containing compound may be used alone or two or more thereof may be used in combination.

When the curable composition contains an alkyleneoxy group-containing compound, the content of the alkyleneoxy group-containing compound in the curable composition with respect to a total amount of the curable composition is, for example, preferably 30 mass% to 70 mass%, preferably 35 mass% to 65 mass%, and still more preferably 40 mass% to 60 mass%. In this case, the shape of the cured product is appropriately maintained, the strength of the cured product tends to be excellent, and oxidative deterioration of the quantum dot phosphor tends to be minimized.

(Liquid medium)

The curable composition of the present disclosure may contain a liquid medium. The liquid medium is a medium that is in a liquid state at room temperature (25°C).

Specific examples of liquid mediums include ketone solvents such as acetone, methyl ethyl ketone, methyl-n-propyl ketone, methyl isopropyl ketone, methyl-n-butyl ketone, methyl isobutyl ketone, methyl-n-pentyl ketone, methyl-n-hexyl ketone, diethyl ketone, dipropyl ketone, diisobutyl ketone, trimethylnonanone, cyclohexanone, cyclopentanone, methylcyclohexanone, 2,4-pentanedione, and acetonylacetone; ether solvents such as diethyl ether, methyl ethyl ether, methyl-n-propyl ether, diisopropyl ether, tetrahydrofuran, methyltetrahydrofuran, dioxane, dimethyldioxane, ethylene glycol dimethyl ether, ethylene glycol diethyl ether, ethylene glycol di-n-propyl ether, ethylene glycol di-n-butyl ether, diethylene glycol dimethyl ether, diethylene glycol diethyl ether, diethylene glycol methyl ethyl ether, diethylene glycol methyl-n-propyl ether, diethylene glycol methyl-n-butyl ether, diethylene glycol di-n-propyl ether, diethylene glycol di-n-butyl ether, diethylene glycol methyl-n-hexyl ether, triethylene glycol dimethyl ether, triethylene glycol diethyl ether, triethylene glycol methyl ethyl ether, triethylene glycol methyl-n-butyl ether, triethylene glycol di-n-butyl ether, triethylene glycol methyl-n-hexyl ether, tetraethylene glycol dimethyl ether, tetra ethylene glycol diethyl ether, tetra ethylene glycol methyl ethyl ether, tetra ethylene glycol methyl-n-butyl ether, tetra ethylene glycol di-n-butyl ether, tetraethylene glycol methyl-n-hexyl ether, propylene glycol dimethyl ether, propylene glycol diethyl ether, propylene glycol di-n-propyl ether, propylene glycol di-n-butyl ether, dipropylene glycol dimethyl ether, dipropylene glycol diethyl ether, dipropylene glycol methyl ethyl ether, dipropylene glycol methyl-n-butyl ether, dipropylene glycol di-n-propyl ether, dipropylene glycol di-n-butyl ether, dipropylene glycol methyl-n-hexyl ether, tripropylene glycol dimethyl ether, tripropylene glycol diethyl ether, tripropylene glycol methyl ethyl ether, tripropylene glycol methyl-n-butyl ether, tripropylene glycol di-n-butyl ether, tripropylene glycol methyl-n-hexyl ether, tetrapropylene glycol dimethyl ether, tetrapropylene glycol diethyl ether, tetrapropylene glycol methyl ethyl ether, tetrapropylene glycol methyl-n-butyl ether, tetrapropylene glycol di-n-butyl ether, and tetrapropylene glycol methyl-n-hexyl ether; carbonate solvents such as propylene carbonate, ethylene carbonate, and diethyl carbonate; ester solvents such as methyl acetate, ethyl acetate, n-propyl acetate, isopropyl acetate, n-butyl acetate, isobutyl acetate, sec-butyl acetate, n-pentyl acetate, sec-pentyl acetate, 3-methoxybutyl acetate, methylpentyl acetate, 2-ethylbutyl acetate, 2-ethylhexyl acetate, 2-(2-butoxyethoxy)ethyl acetate, benzyl acetate, cyclohexyl acetate, methyl cyclohexyl acetate, nonyl acetate, methyl acetoacetate, ethyl acetoacetate, diethylene glycol methyl ether acetate, diethylene glycol monoethyl ether acetate, dipropylene glycol methyl ether acetate, dipropylene glycol ethyl ether acetate, glycol diacetate, methoxytriethylene glycol acetate, ethyl propionate, n-butyl propionate, isoamyl propionate, diethyl oxalate, di-n-butyl oxalate, methyl lactate, ethyl lactate, n-butyl lactate, n-amyl lactate, ethylene glycol methyl ether propionate, ethylene glycol ethyl ether propionate, ethylene glycol methyl ether acetate, ethylene glycol ethyl ether acetate, propylene glycol methyl ether acetate, propylene glycol ethyl ether acetate, propylene glycol propyl ether acetate, γ-butyrolactone, and γ-valerolactone; aprotic polar solvents such as acetonitrile, N-methylpyrrolidinone, N-ethylpyrrolidinone, N-propylpyrrolidinone, N-butylpyrrolidinone, N-hexylpyrrolidinone, N-cyclohexylpyrrolidinone, N,N-dimethylformamide, N,N-dimethylacetamide, and dimethyl sulfoxide; alcohol solvents such as methanol, ethanol, n-propanol, isopropanol, n-butanol, isobutanol, sec-butanol, t-butanol, n-pentanol, isopentanol, 2-methylbutanol, sec-pentanol, t-pentanol, 3-methoxybutanol, n-hexanol, 2-methylpentanol, sec-hexanol, 2-ethylbutanol, sec-heptanol, n-octanol, 2-ethylhexanol, sec-octanol, n-nonyl alcohol, n-decanol, sec-undecyl alcohol, trimethylnonyl alcohol, sec-tetradecyl alcohol, sec-heptadecyl alcohol, cyclohexanol, methylcyclohexanol, benzyl alcohol, ethylene glycol, 1,2-propylene glycol, 1,3-butylene glycol, diethylene glycol, dipropylene glycol, triethylene glycol, and tripropylene glycol; glycol mono ether solvents such as ethylene glycol monomethyl ether, ethylene glycol monoethyl ether, ethylene glycol monophenyl ether, diethylene glycol monomethyl ether, diethylene glycol monoethyl ether, diethylene glycol mono-n-butyl ether, diethylene glycol mono-n-hexyl ether, triethylene glycol monoethyl ether, tetraethylene glycol mono-n-butyl ether, propylene glycol monomethyl ether, dipropylene glycol monomethyl ether, dipropylene glycol monoethyl ether, and tripropylene glycol monomethyl ether; terpene solvents such as terpinene, terpineol, myrsen, alloocimene, limonene, dipentene, pinene, carvone, ocimene, and phellandrene; straight silicone oils such as dimethyl silicone oil, methylphenyl silicone oil, and methyl hydrogen silicone oil; modified silicone oils such as amino modified silicone oil, epoxy modified silicone oil, carboxy modified silicone oil, carbinol modified silicone oil, mercapto modified silicone oil, a different functional group modified silicone oil, polyether modified silicone oil, methylstyryl modified silicone oil, hydrophilic special modified silicone oil, higher alkoxy modified silicone oil, higher fatty acid modified silicone oil, and fluorine modified silicone oil; saturated aliphatic monocarboxylic acids having 4 or more carbon atoms such as butanoic acid, pentanoic acid, hexane acid, heptanoic acid, octanoic acid, nonanoic acid, decanoic acid, undecanoic acid, dodecanoic acid, tridecanoic acid, tetradecanoic acid, pentadecanoic acid, hexadecanoic acid, heptadecanoic acid, octadecanoic acid, nonadecanoic acid, eicosanoic acid, and eicosenoic acid; and unsaturated aliphatic monocarboxylic acid having 8 or more carbon atoms such as oleic acid, elaidic acid, linoleic acid, and palmitoleic acid. When the curable composition contains a liquid medium, it may contain one type of liquid medium alone or two or more types of liquid mediums in combination.

When the curable composition contains a liquid medium, the content of the liquid medium in the curable composition with respect to a total amount of the curable composition is, for example, is preferably 1 mass% to 10 mass%, more preferably 4 mass% to 10 mass%, and still more preferably 4 mass% to 7 mass%.

(White pigment)

The curable composition of the present disclosure may contain a white pigment.
Specific examples of white pigments include titanium oxide, barium sulfate, zinc oxide, and calcium carbonate. Among these, titanium oxide is preferable from the viewpoint of light scattering efficiency.
When the curable composition contains titanium oxide as a white pigment, the titanium oxide may be a rutile type titanium oxide or an anatase type titanium oxide, and is preferably a rutile type titanium oxide.
The average particle size of the white pigment is preferably 0.1 $\mu$m to 1 $\mu$m, more preferably 0.2 $\mu$m to 0.8 $\mu$m, and still more preferably 0.2 $\mu$m to 0.5 $\mu$m.
In the present disclosure, the average particle size of the white pigment can be measured as follows.
The white pigment extracted from the curable composition is dispersed in purified water containing a surfactant to obtain a dispersion. In a volume-based particle size distribution measured using this dispersion by a laser diffraction type particle size distribution measurement device (for example, SALD-3000J commercially available from Shimadzu Corporation), a value (median diameter (D50)) when a cumulative from the small diameter side is 50% is an average particle size of the white pigment. A method of extracting a white pigment from the curable composition may be, for example, a method in which the curable composition is diluted in a liquid medium, and a white pigment is precipitated and collected according to a centrifugation process or the like.
Here, the average particle size of the white pigment contained in the cured product can be obtained as an arithmetic average value by calculating equivalent circle diameters (geometric average of the major axis and the minor axis) of 50 particles and observing the particles using a scanning electron microscope.
When the curable composition contains a white pigment, in order to minimize aggregation of the white pigment in the curable composition, white particles preferably have an organic substance layer containing an organic substance in at least a part of the surface. Examples of organic substances contained in the organic substance layer include organosilane, organosiloxane, fluorosilane, organophosphonate, organophosphate compound, organic phosphinate, organic sulfonic acid compound, carboxylic acid, carboxylic acid ester, derivatives of carboxylic acid, amide, hydrocarbon wax, polyolefin, polyolefin copolymers, polyol, derivatives of polyols, alkanolamine, derivatives of alkanolamines, and organic dispersants.
The organic substance contained in the organic substance layer preferably contains a polyol, an organosilane, or the like, and more preferably contains at least one of a polyol and an organosilane.
Specific examples of organosilanes include octyltriethoxysilane, nonyltriethoxysilane, decyltriethoxysilane, dodecyltriethoxysilane, tridecyltriethoxysilane, tetradecyltriethoxysilane, pentadecyltriethoxysilane, hexadecyltriethoxysilane, heptadecyltriethoxysilane, and octadecyltriethoxysilane.
Specific examples of organosiloxanes include trimethylsilyl functional group-terminated polydimethylsiloxane (PDMS), polymethylhydrosiloxane (PMHS), and polysiloxanes derived from functionalization (hydrosilylation) of PMHS with olefin.
Specific examples of organophosphonates include, for example, n-octylphosphonic acid and esters thereof, n-decylphosphonic acid and esters thereof, 2-ethylhexylphosphonic acid and esters thereof, and camphylphosphonic acid and esters thereof.
Specific examples of organophosphate compounds include organic acid phosphate, organic pyrophosphate, organic polyphosphate, organic metaphosphate, and their salts.
Specific examples of organic phosphinates include, for example, n-hexylphosphinic acid and esters thereof, n-octylphosphinic acid and esters thereof, di-n-hexylphosphinic acid and esters thereof and di-n-octylphosphinic acid and esters thereof.
Specific examples of organic sulfonic acid compounds include alkyl sulfonic acids such as hexylsulfonic acid, octylsulfonic acid, and 2-ethylhexylsulfonic acid, these alkyl sulfonic acids, and salts of metal ions such as sodium, calcium, magnesium, aluminum, and titanium, and organic ammonium ions such as ammonium ions and triethanolamine.

Specific examples of carboxylic acid include maleic acid, malonic acid, fumaric acid, benzoic acid, phthalic acid, stearic acid, oleic acid, and linoleic acid.

Specific examples of carboxylic acid esters include esters that are generated by a reaction between the above carboxylic acid, and a hydroxy compound such as ethylene glycol, propylene glycol, trimethylolpropane, diethanol amine, triethanolamine, glycerol, hexanetriol, erythritol, mannitol, sorbitol, pentaerythritol, bisphenol A, hydroquinone, and phloroglucinol, and partial esters.

Specific examples of amides include stearic acid amide, oleic acidamide, and erucic acid amide.

Specific examples of polyolefins and their copolymers include copolymers of polyethylene, polypropylene, ethylene, and one or two or more compounds selected from among propylene, butylene, vinyl acetate, acrylate, acrylamide, and the like.

Specific examples of polyols include glycerol, trimethylolethane, and trimethylolpropane.

Specific examples of alkanolamines include diethanol amine and triethanolamine.

Specific examples of organic dispersants include a polymer organic dispersant having a functional group such as citric acid, polyacrylic acid, polymethacrylic acid, anionic, cationic, zwitterionic, nonionic acid, and the like.

When aggregation of the white pigment in the curable composition is minimized, the dispersibility of the white pigment in the cured product tends to be improved.

The white pigment may have a metal oxide layer containing a metal oxide in at least a part of the surface. Examples of a metal oxide contained in the metal oxide layer include silicon dioxide, aluminum oxide, zirconia, phosphoria, and boria. The metal oxide layer may be a single layer or two or more layers. When the white pigment has two metal oxide layers, it preferably has a first metal oxide layer containing silicon dioxide and a second metal oxide layer containing aluminum oxide.

When the white pigment has a metal oxide layer, the dispersibility of the white pigment in the cured product having an alicyclic structure and a sulfide structure tends to be improved.

The white pigment may have an organic substance layer and a metal oxide layer. In this case, it is preferable that the metal oxide layer and the organic substance layer be provided on the surface of the white pigment in the order of the metal oxide layer and the organic substance layer. When the white pigment has an organic substance layer and two metal oxide layers, it is preferable that a first metal oxide layer containing silicon dioxide, a second metal oxide layer containing aluminum oxide and an organic substance layer be provided on the surface of the white pigment in the order of the first metal oxide layer, the second metal oxide layer and the organic substance layer.

When the curable composition contains a white pigment, the content of the white pigment in the curable composition with respect to a total amount of the curable composition is, for example, preferably 0.05 mass% to 1.0 mass%, more preferably 0.1 mass% to 1.0 mass%, and still more preferably 0.2 mass% to 0.5 mass%.

(Other components)

The curable composition may further contain other components such as a polymerization inhibitor, a silane coupling agent, a surfactant, an adhesion imparting agent, and an antioxidant. The curable composition may contain one type of each of other components alone or two or more types thereof in combination.

In addition, the curable composition may contain a (meth)allyl compound as necessary.

(Method of preparing curable composition)

The curable composition can be prepared by mixing, for example, a quantum dot phosphor, a specific carboxylic acid, a multifunctional (meth)acrylate compound having an alicyclic structure or an alkyleneoxy group-containing compound, a multifunctional thiol compound, a photopolymerization initiator, and as necessary, the above components, by a general method. The quantum dot phosphor that is dispersed in a dispersion medium is preferably mixed.

(Applications of curable composition)

The curable composition can be appropriately used for film formation. In addition, the curable composition can be appropriately used for forming a wavelength conversion member.

Examples

Hereinafter, the present invention will be described in detail with reference to examples, but the present invention is not limited to these examples.

<Examples 1 to 3 and Comparative Example 1>

(Preparation of curable composition)

The components shown in Table 1 were mixed in formulation amounts (unit: parts by mass) shown in the table to prepare curable compositions of Examples 1 to 3 and Comparative Example 1. "-" in Table 1 means that the component was not added.

Here, regarding the multifunctional (meth)acrylate compound having an alicyclic structure, tricyclodecane dimethanol diacrylate (A-DCP commercially available from Shin-Nakamura Chemical Co., Ltd.) was used.

In addition, regarding the multifunctional thiol compound, pentaerythritol tetrakis(3-mercaptopropionate) (PEMP commercially available from SC Organic Chemical Co., Ltd.,) was used.

In addition, regarding the photopolymerization initiator, 2,4,6-trimethylbenzoyl-diphenyl-phosphine oxide (IRGACURE TPO commercially available from BASF) was used.

In addition, regarding the carboxylic acid, acetic acid, mercaptopropionic acid (commercially available from SC Organic Chemical Co., Ltd.), methacrylic acid (commercially available from Wako Pure Chemical Industries, Ltd.) and oleic acid (commercially available from Wako Pure Chemical Industries, Ltd.) were used.

In addition, regarding the quantum dot phosphor IBOA (isobornyl acrylate) dispersion, a CdSe/ZnS (core/shell) dispersion (Gen3.5 QD Concentrate commercially available from Nanosys) was used. Regarding the dispersion medium for the CdSe/ZnS (core/shell) dispersion, isobornyl acrylate was used. The CdSe/ZnS (core/shell) dispersion contained about 90 mass% of isobornyl acrylate.

In addition, regarding the white pigment, titanium oxide (Ti-Pure R-706, particle size of 0.36 $\mu$m commercially available from Chemours) was used. A first metal oxide layer containing silicon oxide, a second metal oxide layer containing aluminum oxide and an organic substance layer containing a polyol compound were provided on the surface of titanium oxide in the order of the first metal oxide layer, the second metal oxide layer and the organic substance layer.

[Table 1]

| | | Example 1 | Example 2 | Example 3 | Comparative Example 1 |
|---|---|---|---|---|---|
| Multifunctional (meth)acrylate compound | A-DCP | 77.48 | 77.48 | 77.48 | 77.48 |
| Multifunctional thiol compound | PEMP | 19.37 | 19.37 | 19.37 | 19.37 |
| Photopolymerization initiator | TPO | 0.5 | 0.5 | 0.5 | 0.5 |
| Quantum dot phosphor dispersion | GEN3.5 QD Concentrate | 1.61 | 1.61 | 1.61 | 1.61 |
| White pigment | R-706 | 0.25 | 0.25 | 0.25 | 0.25 |
| Carboxylic acid | Acetic acid | 0.79 | - | - | - |
| | Mercaptopropionic acid | - | 0.79 | - | - |
| | Methacrylic acid | - | - | 0.79 | - |
| | Oleic acid | - | - | - | 0.79 |
| Total | | 100 | 100 | 100 | 100 |

(Production of wavelength conversion member)

Each of the curable compositions obtained above was applied to a barrier film having an average thickness of 120 $\mu$m (commercially available from Dai Nippon Printing Co., Ltd.) (covering material) to form a coating film. A barrier film having a thickness of 120 $\mu$m (commercially available from Dai Nippon Printing Co., Ltd.) (covering material) was attached to the coating film, UV rays were emitted using a UV irradiation device (commercially available from Eye Graphics Co., Ltd.) (emission amount: 1,000 mJ/cm$^2$), and thereby a wavelength conversion member in which the covering material was arranged on both surfaces of a cured product containing a resin cured product for wavelength conversion was obtained.

<Evaluation>

The following evaluation items were measured and evaluated using the wavelength conversion members obtained in Examples 1 to 3 and Comparative Example 1. The results are shown in Table 2.

(Moisture and heat resistance)

Each of the wavelength conversion members obtained above was cut into a size of 100 mm in width and 100 mm in length, and then put into a thermohygrostat chamber at 65°C and a relative humidity (RH) of 95%, and left for 480 hours, and a relative emission intensity retention rate of the wavelength conversion member was calculated according to the following formula.

$$\text{Relative emission intensity retention rate: } (RLb1/RLa)\times100$$

RLa: initial relative emission intensity
RLb1: relative emission intensity at 65°C and 95% RH× after 480 hours

(Light resistance)

Each of the wavelength conversion member obtained above was cut into a size of 28 mm in diameter to prepare an evaluation sample. The initial emission intensity of the evaluation sample was measured using a fiber multi-channel spectrometer (Ocean View commercially available from Ocean Photonics). Then, the evaluation sample was placed in a high brightness tester Light BOX (commercially available from Nanosys) (a LED peak wavelength of 448 nm), and the test was performed under an environment of an illuminance of 150 mW/cm$^2$, and 85°C in a thermostatic chamber. After 24 hours, the evaluation sample was taken out, and a relative emission intensity retention rate of the wavelength conversion member was calculated according to the following formula.

$$\text{Relative emission intensity retention rate: } (RLb2/RLa)\times100$$

RLa: initial relative emission intensity
RLb2: relative emission intensity at 150 mW/cm$^2$, 85°C×after 24 hours

Here, a higher numerical value of the relative emission intensity retention rate indicates that the wavelength conversion member has a better light resistance.

[Table 2]

|  | Example 1 | Example 2 | Example 3 | Comparative Example 1 |
|---|---|---|---|---|
| Moisture and heat resistance | 105 | 103 | 107 | 95 |
| Light resistance | 101 | 102 | 93 | 90 |

As can be understood from Table 2, compared to Comparative Example 1 using oleic acid, in Examples 1 to 3 using acetic acid, mercaptopropionic acid or methacrylic acid corresponding to a carboxylic acid having 1 to 17 carbon atoms, the wavelength conversion member had better moisture and heat resistance and light resistance.

<Examples 4 to 9 and Comparative Example 2>

(Preparation of curable composition)

The components shown in Table 3 were mixed in formulation amounts (unit: parts by mass) shown in the table to prepare curable compositions of Examples 4 to 9 and Comparative Example 2. "-" in Table 3 means that the component was not added.
Here, in Table 3, the above Examples 1 to 3 and Comparative Example 1 are also shown for comparison.
In Table 3, the mass ratios of carboxylic acid/quantum dot phosphor in the examples and the comparative examples are shown. Since 10 mass% of the quantum dot phosphor as a solid content was contained in the quantum dot phosphor dispersion, the mass ratio of carboxylic acid/quantum dot phosphor was calculated based on the following formula.

$$\text{Mass ratio of carboxylic acid/quantum dot phosphor} = \text{carboxylic acid (parts by mass)}/[\text{quantum dot phosphor dispersion (parts by mass)} \times 0.1]$$

(Production of wavelength conversion member and evaluation of moisture and heat resistance and light resistance)

In Examples 4 to 9 and Comparative Example 2, wavelength conversion members were produced in the same manner as in Example 1. The moisture and heat resistance and light resistance of the obtained wavelength conversion members were evaluated in the same manner as in Example 1.
The results are shown in Table 3.

[Table 3]

| Material name | | Example 1 | Example 2 | Example 3 | Comparative Example 1 | Example 4 | Example 5 | Example 6 | Example 7 | Example 8 | Example 9 | Comparative Example 2 |
|---|---|---|---|---|---|---|---|---|---|---|---|---|
| Multifunctional (meth) acrylate compound | A-DCP | 77.48 | 77.48 | 77.48 | 77.48 | 77.31 | 78.05 | 77.32 | 78.05 | 76.24 | 72.16 | 78.11 |
| Multifunctional thiol compound | PEMP | 19.37 | 19.37 | 19.37 | 19.37 | 19.33 | 19.51 | 19.33 | 19.51 | 19.06 | 18.04 | 19.53 |
| Photopolymerization initiator | TPO | 0.5 | 0.5 | 0.5 | 0.5 | 0.5 | 0.5 | 0.5 | 0.5 | 0.5 | 0.5 | 0.5 |
| Quantum dot phosphor dispersion | GEN3.5 QD Concentrate | 1.61 | 1.61 | 1.61 | 1.61 | 1.61 | 1.61 | 1.61 | 1.61 | 3.55 | 8.55 | 1.61 |
| White pigment | R-706 | 0.25 | 0.25 | 0.25 | 0.25 | 0.25 | 0.25 | 0.25 | 0.25 | 0.15 | 0.25 | 0.25 |
| Carboxylic acid | Acetic acid | 0.79 | - | - | - | 1.00 | 0.08 | - | - | - | - | - |
| | Mercaptopropionic acid | - | 0.79 | - | - | - | - | 0.99 | 0.08 | 0.50 | 0.50 | - |
| | Methacrylic acid | - | - | 0.79 | - | - | - | - | - | - | - | - |
| | Oleic acid | - | - | - | 0.79 | - | - | - | - | - | - | - |
| Total | | 100 | 100 | 100 | 100 | 100 | 100 | 100 | 100 | 100 | 100 | 100 |
| Mass ratio of carboxylic acid/quantum dot phosphor | | 4.91 | 4.91 | 4.91 | 4.91 | 6.21 | 0.50 | 6.15 | 0.50 | 1.41 | 0.58 | 0.00 |
| Moisture and heat resistance | | 105 | 103 | 107 | 95 | 106 | 100 | 105 | 106 | 100 | 102 | 88 |
| Light resistance | | 101 | 102 | 93 | 90 | 102 | 99 | 101 | 102 | 99 | 100 | 78 |

As can be understood from Table 3, compared to Comparative Example 1 using oleic acid and Comparative Example 2 in which no carboxylic acid was used, in Examples 1 to 9 using acetic acid, mercaptopropionic acid or methacrylic acid corresponding to a carboxylic acid having 1 to 17 carbon atoms, the wavelength conversion members had excellent moisture and heat resistance and light resistance.

Priority is claimed on PCT/JP2018/012584, filed March 27, 2018, the content of which is incorporated herein by reference.

All references, patent applications, and technical standards described in this specification are incorporated herein by reference to the same extent as if it were specifically and individually noted that the individual references, patent applications, and technical standards are incorporated by reference.

**Claims**

1. A wavelength conversion member comprising a cured product of a curable composition which contains a quantum dot phosphor and a carboxylic acid having 1 to 17 carbon atoms.

2. The wavelength conversion member according to claim 1,
   wherein the cured product has an alicyclic structure in the skeleton of the cured product.

3. The wavelength conversion member according to claim 2,
   wherein the alicyclic structure comprises an isobornyl skeleton.

4. The wavelength conversion member according to claim 2 or 3,
   wherein the alicyclic structure comprises a tricyclodecane skeleton.

5. The wavelength conversion member according to any one of claims 1 to 4,
   wherein the cured product comprises a white pigment.

6. The wavelength conversion member according to claim 5,
   wherein an average particle size of the white pigment is 0.1 $\mu$m to 1.0 $\mu$m.

7. The wavelength conversion member according to any one of claims 1 to 6,
   wherein the quantum dot phosphor comprises a compound containing at least one of Cd and In.

8. The wavelength conversion member according to any one of claims 1 to 7, further comprising a covering material that covers at least a part of the cured product.

9. The wavelength conversion member according to claim 8,
   wherein the covering material has a barrier property against oxygen.

10. The wavelength conversion member according to any one of claims 1 to 9,
    wherein the carboxylic acid comprises at least one selected from the group consisting of acetic acid, mercaptopropionic acid and methacrylic acid.

11. The wavelength conversion member according to any one of claims 1 to 10,
    wherein a mass-based content ratio of the carboxylic acid to the quantum dot phosphor (carboxylic acid/quantum dot phosphor) is 0.06 to 6.5.

12. The wavelength conversion member according to any one of claims 1 to 10,
    wherein the carboxylic acid is acetic acid, and a mass-based content ratio of the carboxylic acid to the quantum dot phosphor (carboxylic acid/quantum dot phosphor) is 0.5 to 6.5.

13. The wavelength conversion member according to any one of claims 1 to 10,
    wherein the carboxylic acid is mercaptopropionic acid, and a mass-based content ratio of the carboxylic acid to the quantum dot phosphor (carboxylic acid/quantum dot phosphor) is 0.06 to 6.5.

14. The wavelength conversion member according to any one of claims 1 to 13,
    wherein a content of the quantum dot phosphor in the curable composition with respect to a total amount of the curable composition is 0.15 mass% to 0.3 mass%.

15. A backlight unit comprising the wavelength conversion member according to any one of claims 1 to 14, and a light source.

16. An image display device comprising the backlight unit according to claim 15.

17. A curable composition comprising a quantum dot phosphor and a carboxylic acid having 1 to 17 carbon atoms.

18. The curable composition according to claim 17,
wherein a mass-based content ratio of the carboxylic acid to the quantum dot phosphor (carboxylic acid/quantum dot phosphor) is 0.06 to 6.5.

19. The wavelength conversion member according to claim 17,
wherein the carboxylic acid is acetic acid, and a mass-based content ratio of the carboxylic acid to the quantum dot phosphor (carboxylic acid/quantum dot phosphor) is 0.5 to 6.5.

20. The wavelength conversion member according to claim 17,
wherein the carboxylic acid is mercaptopropionic acid, and a mass-based content ratio of the carboxylic acid to the quantum dot phosphor (carboxylic acid/quantum dot phosphor) is 0.06 to 6.5.

21. The wavelength conversion member according to any one of claims 17 to 20,
wherein a content of the quantum dot phosphor in the curable composition with respect to a total amount of the curable composition is 0.15 mass% to 0.3 mass%.

22. The curable composition according to any one of claims 17 to 21, further comprising
a multifunctional (meth)acrylate compound having an alicyclic structure, a multifunctional thiol compound and a photopolymerization initiator.

23. The curable composition according to claim 22,
wherein the multifunctional (meth)acrylate compound having an alicyclic structure is a compound containing a tricyclodecane skeleton.

24. The curable composition according to any one of claims 17 to 21, further comprising
an alkyleneoxy group-containing compound having an alkyleneoxy group and a polymerizable reactive group, a multifunctional thiol compound, and a photopolymerization initiator.

25. The curable composition according to any one of claims 17 to 24, further comprising a white pigment.

26. The curable composition according to any one of claims 17 to 25, further comprising an isobornyl (meth)acrylate.

Fig. 1

Fig. 2

Fig. 3

**INTERNATIONAL SEARCH REPORT**

| International application No. |
|---|
| PCT/JP2019/013416 |

A. CLASSIFICATION OF SUBJECT MATTER
Int.Cl. G02B5/20(2006.01)i, H01L33/50(2010.01)i

According to International Patent Classification (IPC) or to both national classification and IPC

B. FIELDS SEARCHED

Minimum documentation searched (classification system followed by classification symbols)
Int.Cl. G02B5/20, H01L33/50

| Documentation searched other than minimum documentation to the extent that such documents are included in the fields searched | |
|---|---|
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y<br><br>A | WO 2011/155614 A1 (ASAHI GLASS CO., LTD.) 15 December 2011, paragraphs [0126], [0131], [0172], [0187], table 1 & US 2013/0098438 A1 paragraphs [0161], [0166], [0210], [0227], table 1 & EP 2581943 A1 & CN 102939663 A & TW 201216481 A | 1, 7, 10–11, 13, 17–18, 20–21<br>2–6, 8–10, 12, 19, 22–26<br>14–16 |
| Y<br>A | JP 2012-219193 A (DENSO CORP.) 12 November 2012, paragraphs [0002], [0030], [0035], example 1 (Family: none) | 1–11, 13–26<br>12 |

☒ Further documents are listed in the continuation of Box C.　　☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 14 June 2019 (14.06.2019) | 25 June 2019 (25.06.2019) |

| Name and mailing address of the ISA/<br>　　Japan Patent Office<br>　　3-4-3, Kasumigaseki, Chiyoda-ku,<br>　　Tokyo 100-8915, Japan | Authorized officer<br><br>Telephone No. |
|---|---|

Form PCT/ISA/210 (second sheet) (January 2015)

**INTERNATIONAL SEARCH REPORT**

International application No.

PCT/JP2019/013416

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2009/148131 A1 (SUMITOMO BAKELITE CO., LTD.) 10 December 2009, paragraph [0084] & US 2011/0162711 A1 paragraph [0108] | 2 |
| Y | WO 2017/068781 A1 (FUJIFILM CORP.) 27 April 2017, paragraphs [0038], [0206] & JP 2017-78120 A | 2-3, 10, 26 |
| Y | JP 2018-013672 A (DAINIPPON PRINTING CO., LTD.) 25 January 2018, paragraphs [0046], [0199] (Family: none) | 2, 4, 23 |
| Y | JP 2014-229901 A (DAXIN MATERIALS CORP.) 08 December 2014, paragraph [0015], examples & US 2014/0339585 A1 paragraph [0008], examples & TW 201445778 A & CN 104164197 A | 5-6, 25 |
| Y | JP 2017-537351 A (3M INNOVATIVE PROPERTIES CO.) 14 December 2017, claims, paragraphs [0022]-[0057] & US 2018/0282617 A1 & WO 2016/081219 A1 page 4, line 14 to page 12, line 16 & EP 3221421 A1 & KR 10-2017-0086566 A & CN 107109209 A | 2, 8-9, 21-24 |
| Y | WO 2018/047758 A1 (SUMITOMO CHEMICAL CO., LTD.) 15 March 2018, paragraph [0187] & JP 2018-44158 A & TW 201819488 A | 12, 19 |
| Y | JP 2017-137451 A (DAINIPPON PRINTING CO., LTD.) 10 August 2017, claims (Family: none) | 1-11, 13-26 |
| X | JP 2017-021322 A (DONGWOO FINE-CHEM CO., LTD.) 26 January 2017, paragraphs [0072]-[0077], tables 2, 4, comparative example 6 & KR 10-2017-0006024 A & CN 106338885 A & TW 201702353 A | 1, 10-11, 17-18 |
| A | | 2-9, 12-16, 19-26 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016052625 A
- JP 2018012584 W